# DEMANDE DE BREVET EUROPEEN

(11) **EP 0 851 586 A1**
(43) Date de publication de la demande: **01.07.1998**
(21) Numéro de dépôt: 97204004.2
(22) Date de dépôt: 18.12.1997
(51) Int. Cl.: H03K 17/60, H03K 19/018, H03K 19/013, H03K 17/0412, H03L 7/089

(54) **Circuit intégré contenant un dissymétriseur**

(30) Priorité: 31.12.1996 FR 9616262
(71) Demandeur: Philips Electronics N.V., 5621 BA Eindhoven (NL)
(72) Inventeur: Ridgers, Timothy, 75008 Paris (FR)
(74) Mandataire: Caron, Jean

(57) **Abrégé**

Pour transformer un signal symétrique en un signal dissymétrique, le dissymétriseur comporte une source de courant comprenant un transistor PNP 313 monté en émetteur suiveur avec une résistance de charge 315 depuis l'alimentation VCC, transistor qui est brutalement commandé à la fois sur l'émetteur et sur la base par les courants sortant d'une paire différentielle NPN 312, elle même commandée par une entrée symétrique ON/OFF.

Applications : circuits intégrés.

## Description

La présente invention concerne un circuit intégré contenant un dissymétriseur pour transformer un signal symétrique d'entrée en un signal dissymétrique de sortie.

Un tel circuit dissymétriseur est utilisable en général dans tous les cas où un signal symétrique d'entrée est à transformer en un signal dissymétrique de sortie, notamment dans une pompe de charge dont un circuit de déclenchement fournit un signal symétrique pour déclencher une source de courant dissymétrique, ou encore, par exemple, comme interface entre un circuit logique amont en technique dite CML ou ECL, et un circuit aval en technique dite I2L ou ISL ou MOS.

Un circuit dissymétriseur dégrade la raideur des transitions du signal de façon préjudiciable. L'invention a entre autres pour but de procurer un circuit dissymétriseur dont la vitesse soit très élevée.

A cet effet, le dissymétriseur comprend une source de courant de sortie faite d'un transistor dit transistor source, en série avec une résistance, transistor source qui est commandé par une paire dite paire différentielle, faite de transistors de polarité opposée à celle du transistor source, dont les bases sont attaquées par le dit signal symétrique d'entrée, un des transistors de la paire commandant la base du transistor source et l'autre commandant l'émetteur du transistor source.

Avantageusement, le circuit dissymétriseur comporte un transistor de polarité opposée à celle du transistor source, dont l'émetteur est relié à la base du transistor source, et dont la base est reliée à une tension de référence.

Ceci permet d'accélérer encore la commutation du transistor source.

De préférence, les valeurs des éléments sont telles que le potentiel sur l'émetteur du transistor source, dans l'état bloqué, est proche de celui attendu dans l'état conducteur.

Un circuit intégré ou une pompe de charge sont avantageusement munis d'un circuit dissymétriseur selon l'invention.

Ces aspects de l'invention ainsi que d'autres aspects plus détaillés apparaîtront plus clairement grâce à la description suivante d'un mode de réalisation constituant un exemple non limitatif.

La figure 1 est un schéma détaillé d'un circuit dissymétriseur selon l'invention.

La figure 2 est un schéma de circuit de déclenchement et de commande pour une pompe de charge, susceptible d'incorporer un circuit dissymétriseur selon l'invention.

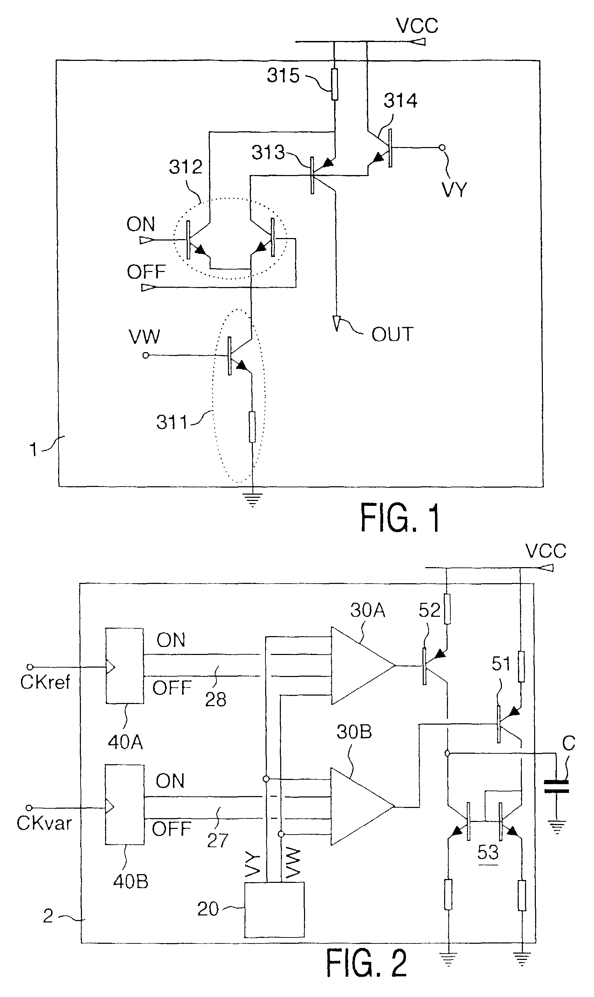

Le circuit intégré 1 représenté par la figure 1 comporte un dissymétriseur muni d'une source de courant faite d'un transistor comprenant un transistor PNP 313, dit transistor source, monté en émetteur suiveur avec son émetteur relié à l'alimentation VCC va résistance de charge 315, et dont le collecteur constitue la sortie OUT du montage. Ce transistor est brutalement commandé à la fois sur l'émetteur et sur la base par les courants sortant d'une paire différentielle NPN 312, elle même commandée par une entrée symétrique ON/OFF, et alimentée par une source de courant 311 recevant une tension de référence VW fournie par un circuit de polarisation connu. La base du transistor PNP est connectée à l'émetteur d'un transistor 314 dont la base est polarisée par une tension VY fournie par le circuit de polarisation et dont le collecteur est relié à l'alimentation VCC. Une charge quelconque dissymétrique peut être connectée à la sortie OUT.

Ces circuits doivent agir en quelques nanosecondes. Le circuit dissymétriseur crée un courant commuté rapidement, sortant du transistor source 313. Lorsque le transistor source 313 est au repos, la paire 312 est polarisée par la différence de polarisation des bases de telle façon que le courant de la source 311 passe par celui des transistors 312 qui est connecté à l'émetteur du transistor PNP 313, relié à l'alimentation par la résistance 315. Le collecteur de l'autre transistor 312 n'envoie que très peu de courant vers la base du transistor PNP 313, et ce peu de courant sert à polariser l'émetteur du transistor 314. Les valeurs des éléments sont choisies pour que le potentiel sur l'émetteur du transistor PNP soit proche de celui attendu dans l'état opposé (transistor source 313 actif). Ainsi lorsqu'il y a commutation, le transistor PNP voit simultanément un courant entrant à son émetteur et un fort appel de courant à sa base, et sa mise en conduction est particulièrement rapide. L'arrêt suit la démarche inverse et est rapide également.

La pompe de charge 2 de la figure 2 comporte un circuit de déclenchement et de commande muni de circuits de commande 30A, 30B utilisés pour commander chacun le courant d'une source de courant respectivement de charge et de décharge de la pompe de charge. Elle comporte un étage de sortie fait d'une source de courant de charge de sortie, réalisée à partir d'un transistor 52 dont l'émetteur est relié via une résistance à l'alimentation VCC et dont la base est commandée par le signal sortant du circuit de commande 30A, et d'une source de courant de décharge de sortie, réalisée à partir d'un transistor 51 commandé par le signal sortant du circuit de commande 30B, et dont le courant est "retourné" par un miroir de courant 53 du côté masse. Les courants de ces deux sources se retranchent l'un de l'autre à la sortie, dans une capacité C.

Un signal à comparer est amené à l'entrée d'horloge Ckvar d'un circuit de déclenchement 40B, et un signal pilote est amené à une entrée Ckref d'un autre circuit de déclenchement 40A. La pulsation du courant de sortie de chacun des circuits de commande 30A, 30B est initiée par chacun des circuits 40A, 40B. Un signal de sortie symétrique 28 du circuit de déclenchement 40A est amené à une entrée symétrique du circuit de commande 30A dont la sortie dissymétrique commande la source de courant de charge de sortie 52, et le signal de sortie symétrique 27 du circuit de déclenchement 40B est amené à une entrée symétrique du circuit de commande 30B dont la sortie dissymétrique commande la source de courant de décharge de sortie 51. Chacun des circuits de commande 30A ou 30B contient un circuit dissymétriseur selon l'invention pour transformer la commande ON/OFF en un courant dissymétrique, appliqué aux bases des transistors 51, 52. Les tensions de polarisation VW, VY, communes aux deux circuits, viennent d'un circuit de polarisation 20.

## Revendications

1. Circuit intégré contenant un dissymétriseur pour transformer un signal symétrique d'entrée en un signal dissymétrique de sortie, **caractérisé en ce que** le dissymétriseur comprend une source de courant de sortie faite d'un transistor dit transistor source, en série avec une résistance, transistor source qui est commandé par une paire dite paire différentielle, faite de transistors de polarité opposée à celle du transistor source, dont les bases sont attaquées par le signal symétrique d'entrée, un des transistors de la paire commandant la base du transistor source et l'autre commandant l'émetteur du transistor source.

2. Circuit intégré selon la revendication 1, **caractérisé en ce que** le dissymétriseur comporte un transistor de polarité opposée à celle du transistor source, dont l'émetteur est relié à la base du transistor source, et dont la base est reliée à une tension de référence.

3. Circuit intégré selon l'une des revendications 1 ou 2, **caractérisé en ce que** les valeurs des éléments du dissymétriseur sont telles que le potentiel sur l'émetteur du transistor source, dans l'état bloqué, est proche de celui attendu dans l'état conducteur.

4. Circuit intégré selon l'une quelconque des revendications 1 à 3, **caractérisé en ce que** le dissymétriseur est un élément d'une pompe de charge.
